(19) Europäisches Patentamt
European Patent Office
Office européen des brevets

(11) **EP 2 688 119 A1**

(12) **EUROPEAN PATENT APPLICATION**

(43) Date of publication:
**22.01.2014 Bulletin 2014/04**

(51) Int Cl.:
***H01L 51/50*** *(2006.01)*

(21) Application number: **12177312.1**

(22) Date of filing: **20.07.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **OSRAM GmbH**
  **80807 München (DE)**
- **Universitat de Valencia**
  **46010 Valencia (ES)**

(72) Inventors:
- **Sarfert, Wiebke Dr.**
  **91074 Herzogenaurach (DE)**
- **Hartmann, David Dr.**
  **91056 Erlangen (DE)**
- **Schmid, Günter Dr.**
  **91334 Hemhofen (DE)**
- **Meier, Sebastian**
  **91090 Effeltrich (DE)**
- **Eckert, Helmut**
  **91341 Röttenbach (DE)**
- **Vollkommer, Frank Dr.**
  **82131 Gauting (DE)**
- **Bolink, Hendrik Jan Dr.**
  **46010 Valencia (ES)**
- **Lenes, Martijn Dr.**
  **46010 Valencia (ES)**
- **Pertegas Ojeda, Antonio**
  **46010 Valencia (ES)**
- **Tordera Salvador, Daniel**
  **46010 Valencia (ES)**

(74) Representative: **Epping - Hermann - Fischer Patentanwaltsgesellschaft mbH**
**Ridlerstrasse 55**
**80339 München (DE)**

(54) **Organic electroluminescent device and a method of operating an organic electroluminescent device**

(57) An organic electroluminescent device (100) comprises a substrate (1), a first electrode (2) arranged on the substrate (1), a functional organic layer (3) arranged on the first electrode (2), wherein the functional organic layer (3) emits electromagnetic radiation, a second electrode (4) arranged on the functional organic layer (3), wherein the functional organic layer (3) comprises at least one ionic component and one emitter material having a band gap, wherein the emitter material is selected from the group of ionic transition metal complex, neutral transition metal complex, polymer emitter and combinations thereof, wherein the organic electroluminescent device (100) is adapted to work in two modes, wherein a pre-biasing mode comprises applying a first voltage being a constant or pulsed value less than and/or equal to the band gap to the first (2) and the second electrode (4), wherein an operation mode comprises applying a second voltage being higher than the band gap to the first (2) and the second electrode (4).

Fig. 1

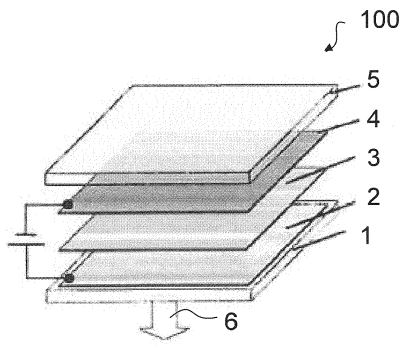


EP 2 688 119 A1

## Description

The invention relates to an organic electroluminescent device and a method of operating an organic electroluminescent device.

In the simplest configuration, an organic electroluminescent device, for example an organic light emitting electrochemical cell (OLEEC), comprises at least one light-emitting functional organic layer sandwiched between two contacts, such as electrodes. Under the application of an electrical field electrons are injected from a cathode into the lowest unoccupied molecular orbital (LUMO) of the light-emitting functional organic layer and migrate towards an anode. Correspondingly, holes are injected from the anode into the highest occupied molecular orbital (HOMO) in the functional organic layer and migrate towards the cathode. When holes and electrons meet in the functional organic layer they may form an excited state which emits electromagnetic radiation, such as visible light. If only one functional organic layer is included in the organic electroluminescent device, the functional organic layer has to fulfill at least three tasks: transport of electrons and holes as well as emission of light with high luminescence efficiency. The functional organic layer can include organic semiconductors, for example ionic transition metal complexes, which support all three processes of charge injection, charge transport and emission recombination.

However, the ionic mobility of the ionic organic semiconductors is low due to the amorphous morphology distribution of the functional organic layer and/or the organic semiconductor, which leads to delayed turn-on times of the organic electroluminescent device. Indeed, the normal range of turn-on time in such ionic organic semiconductors based OLEEC devices ranges from minutes to hours even several days until the luminance reaches its maximum value. Therefore, the turn-on time is the most important limiting factor for technological applications.

To overcome the delayed turn-on times several strategies have been reported. Chemical modifications of the ionic transition metal complexes increasing the amount of mobile ionic species, using ionic liquids as matrix material instead of polymers, a pre-biasing method using high voltages or short pulses of high voltages, and even a combination of theses strategies have been used to increase the mobility of the counter-anions and improving the turn-on times.

Unfortunately, all these strategies are accompanied by a dramatic decrease of the stability of the OLEEC. Up to now, the decrease of the turn-on time without sacrificing the stability of these devices has been impossible.

The objective of the invention is to provide an organic electroluminescent device and a method of operating an organic electroluminescent device with a low turn-on time without sacrificing the stability of organic electroluminescent device and/or a high stability of an organic electroluminescent device without sacrificing the low turn-on time.

This objective is achieved by an organic electroluminescent device in accordance with Claim 1. Particularly advantageous configurations of the organic electroluminescent device and the operating process are the subject of further claims.

An organic electroluminescent device comprises a substrate, a first electrode arranged on the substrate, a functional organic layer arranged on the first electrode, wherein the functional organic layer emits electromagnetic radiation, a second electrode arranged on the functional organic layer, wherein the functional organic layer comprises at least one ionic component and one emitter material having a band gap, wherein the emitter material is selected from the group of ionic transition metal complex, neutral transition metal complex, polymer emitter and combinations thereof, wherein the organic electroluminescent device is adapted to work in two modes, wherein a pre-biasing mode comprises applying a first voltage being a constant or pulsed value less than and/or equal to the band gap to the first and the second electrode, wherein an operation mode comprises applying a second voltage being higher than the band gap to the first and the second electrode.

The first voltage ($U_B$) and/or second voltage ($U_O$) in Volt (V) can here and hereinafter also referred to as the first potential ($E_B$) and/or second potential ($E_O$) in electron volt (eV). "Potential" means here and in the following an energy in eV. The first voltage and second voltage can be converted into the first potential and the second potential and vice versa, respectively ($U_B = e \cdot E_B$ and/or $U_O = e \cdot E_O$ with e - elementary charge 1.602176565 (35) $\times 10^{-19}$ C).

Thereby, the organic electroluminescent device can be embodied as an organic light emitting electrochemical cell (OLEEC). The organic electroluminescent device or the OLEEC can have a substrate, for example, wherein the first electrode can be arranged on the substrate. Since the first electrode can be embodied in a reflective fashion and the second electrode in a transparent fashion, this would result in that the electromagnetic radiation can be emitted in a direction away from the substrate ("top emitter"). As an alternative, the second electrode can be arranged directly on the substrate or the first electrode arranged directly on the substrate is embodied in transparent fashion, such that the electromagnetic radiation can be emitted through the substrate ("bottom emitter"). As an alternative, both the first and the second electrode can be transparent to the emitted electromagnetic radiation ("top and bottom emitter"). Additionally, an encapsulation can be applied above the second electrode.

In this case, the fact that a layer or an element is arranged or applied "on" or "above" an another layer or an another element or else "between" two further layers or elements can mean here and hereinafter that the layer or the element is arranged directly in direct mechanical and/or electrical contact on the another layer or the another element or with the two further layers or elements. Furthermore, an indirect contact can also be designated, in the case of which

further layers and/or elements are arranged between the layer or the element and the another layer or the another element or the two further layers or elements.

By way of example, the substrate can comprise glass, quartz, plastic films, metal, metal films, silicon wafers or any other suitable substrate material. If the organic electroluminescent device or the OLEEC is embodied as a so-called "bottom emitter", that is to say that the electromagnetic radiation generated in the active region is emitted through the substrate, then the substrate can be transparent to at least part of the electromagnetic radiation.

The first electrode, which can be transparent and/or embodied as an anode and can thus serve as hole injecting material, can for example comprise a transparent conductive oxide or consist of a transparent conductive oxide. Transparent conductive oxides ("TCO" for short) are transparent conductive materials, generally metal oxides, such as, for example, zinc oxide, tin oxide, cadmium oxide, titanium oxide, indium oxide or indium tin oxide (ITO). Alongside binary metal-oxygen compounds such as ZnO, $SnO_2$ or $In_2O_3$, for example, the group of the TCOs also includes ternary metal-oxygen compounds such as, for example, $Zn_2SnO_4$, $CdSnO_3$, $ZnSnO_3$, $MgIn_2O_4$, $GaInO_3$, $Zn_2In_2O_5$ or $In_4Sn_3O_{12}$ or mixtures of different transparent conductive oxides. Furthermore, it can be possible that the TCOs do not necessarily correspond to a stoichiometric composition and can also be p- or n-doped.

The second electrode can be embodied as a cathode and thus serve as electron injecting material. Inter alia in particular aluminum, barium, indium, silver, gold, magnesium, calcium or lithium and compounds, combinations and alloys thereof can be used as material of the second electrode.

Preferably, the material of the second electrode is selected from the group including aluminum, silver, gold, combinations and alloys thereof. This material of the second electrode is air-stable and/or no reactive. Therefore, a hermetic sealing of the organic electroluminescent device is less demanding compared to typical OLED. This saves costs and time in the production of the organic electroluminescent device of this invention.

As an alternative, or, in addition, the first electrode can also comprise a metal, for example as mentioned in connection with the second electrode. By way of example, the first electrode can comprise a metal layer that is at least partly transparent to the electromagnetic radiation. Furthermore, the first electrode can also comprise an organic electrically conductive material.

In an embodiment, the organic electroluminescent device comprises at least one functional organic layer. Preferably, the organic electroluminescent device includes only one functional organic layer. The one functional organic layer supports the processes of charge injection, charge transport and emission recombination. Multi-layer structures of functional organic layers like electron and/or hole transporting, electron and/or hole blocking and/or emitting layers are not needed for charge injection, charge transport and light emission. This saves material, costs and time for the production of the organic electroluminescent device of this invention.

The functional organic layer can comprise organic polymers, organic oligomers, organic monomers, organic small, non-polymeric molecules ("small molecules") or combinations thereof. Depending on the materials in the functional organic layer, the electromagnetic radiation generated can have individual wavelengths or wavelength ranges or combinations thereof from the ultraviolet to infrared spectral range.

According to one embodiment, the ionic component is a salt or an electrolyte. Salt means an ionic compound that results from the neutralization reaction of an acid and a base. Salt is composed of at a cation (positively charged ion) and an anion (negative ion) so that the product is electrically neutral (without a net charge). Anion can be inorganic such as chloride ($Cl^-$), as well as organic such as acetate ($CH_3COO^-$) and monatomic ions such as fluoride ($F^-$), as well as polyatomic ions such as sulfate ($SO_4^{2-}$). An electrolyte means any substance containing free ions that make the substance electrically conductive.

According to one embodiment, the emitter material, for example ionic transition metal complex, and the ionic component are identical. This means that the functional organic layer comprises or consists of the ionic transition metal complex as the charge carrier.

"Electromagnetic radiation" is here and in the following, in particular electromagnetic radiation having one or more wavelengths or wavelength ranges from an ultraviolet to infrared spectral range, referred to as light. Light comprises particularly visible light and wavelengths or wavelength ranges from a visible spectral range between about 350 nm and about 800 nm.

According to one embodiment, the functional organic layer comprises at least one ionic transition metal complex having a band gap. As an alternative, or, in addition, the ionic transition metal complex is balanced with a small counter-ion, such as perchlorate ($ClO^{4-}$) tetrafluorborate ($BF_4^-$), $CF_3SO_3^-$, $(CF_3SO_2)\ N^-$, diethylphosphate $(EtO)_2PO_4^-$ and /or hexafluorophosphate ($PF^{6-}$). In principle, another counter-ion is possible which accompanies the ionic transition metal complex in order to maintain electric neutrality.

According to another embodiment, the functional organic layer comprises more than one ionic transition metal complex, which differs from one another.

According to one embodiment, an organic semiconductor comprises at least the ionic transition metal complex or the ionic transition metal complex and its counter-ion.

In this context "ionic" means that the total number of electrons of an atom or molecule is not equal to their total

number of protons and thus the atom or molecule has a net positive or negative electrical charge.

The "band gap" refers to the energy difference between the highest occupied molecular orbital (HOMO) and the lowest unoccupied molecular orbital (LUMO) in an insulator and/or organic semiconductor including the ionic transition metal complex. The energy difference between the HOMO and LUMO is also termed the HOMO-LUMO gap.

According to one embodiment, a transition metal of the ionic transition metal complex is selected from the group including a transition metal of the platinum group of the periodic table and a transition metal of the copper group of the periodic table.

Preferably, the ionic transition metal complex is an ionic ruthenium complex, an ionic copper complex and/or an ionic iridium complex. The ionic transition metal complex can be selected from the group of

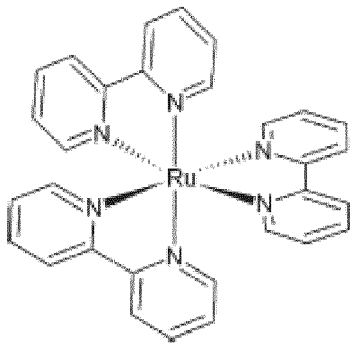
,

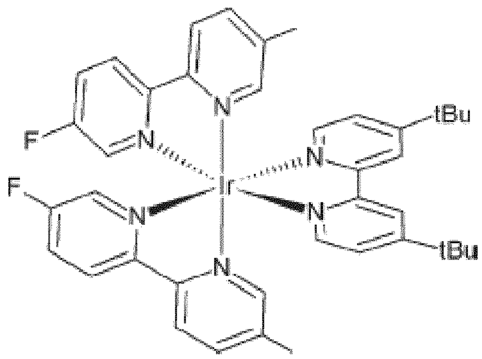
,

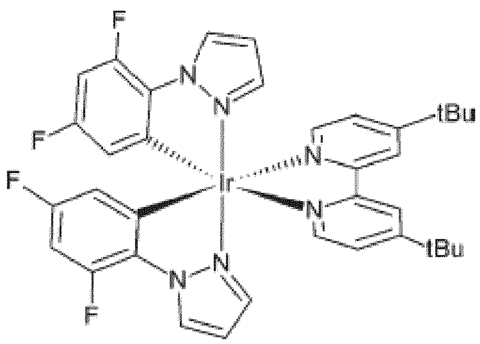
,

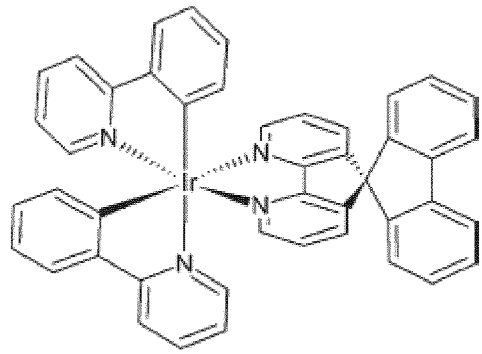
,

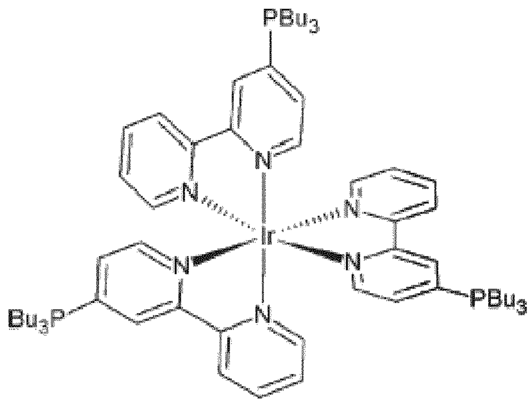
,

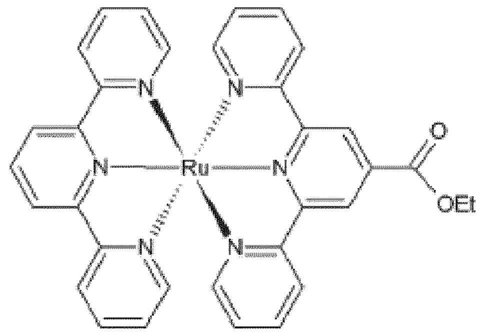
,

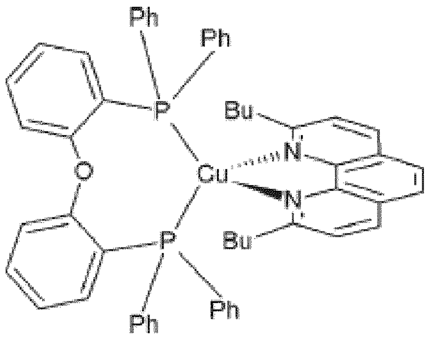

,

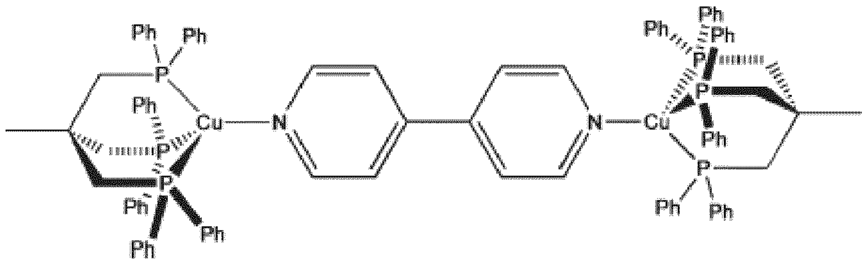

,

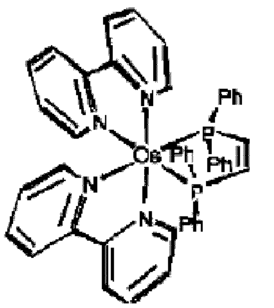

including derivates and combination thereof. tBu means tert-butyl. Et means ethyl. Bu means butyl. Ph means phenyl. The counter-ion can be for example $PF_6^-$, $ClO_4^-$, $ASF_6^-$ or $BF_4^-$.

In particular, the ionic transition metal complex is bis-2-phenylpyridine 6-phenyl-2,2'-bipyridine iridium(III) and derivatives thereof.

The counter-ion of the ionic transition metal complex is particularly hexafluorophosphate.

In particular, the organic semiconductor is bis-2-phenylpyridine 6-phenyl-2,2'-bipyridine iridium(III) hexafluorophosphate and derivatives thereof as shown in the following formula:

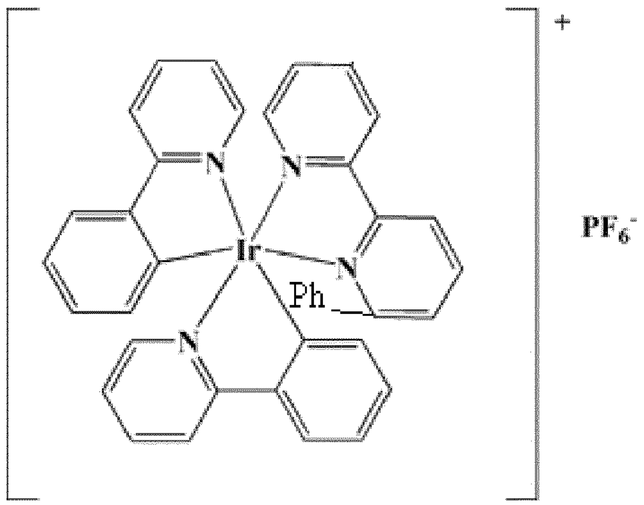

The symbol Ph of the above mentioned formula means a phenyl group or phenyl ring with the formula $C_6H_5$.

The ionic transition metal complex, particularly the ionic copper complex, ionic osmium complex and/or ionic iridium complex improve(s) the turn-on time, efficiency, brightness, stability and activate all the colours of OLEECs even using other different ionic transition metal complex in the functional organic layer.

"Efficiency" means the ratio of photons emerging from the organic electroluminescent device per electron injected.

The ionic transition metal complex shows an excellent stability in multiple redox states. The electronic charges of the first and second electrode can be readily injected and transported.

The ionic transition metal complex and/or the counter-ion are ionically conducting and/or mobile. When an electric field is applied the mobile ions redistribute under the electric field. As a result ionic double layers are formed at the electrode interfaces leading to high electric fields making both contacts ohmic, thus facilitating the charge injection into the functional organic layer. The field in the bulk material is close to zero and the charges move due to diffusion. The injection of holes and electrons causes oxidation and reduction of the organic semiconductor which results in formation of p- and n-doped fronts that propagate to form a dynamic p-n junction. In this state the electric field is concentrated in the vicinity of the p-n junction and the charges migrate due to drift. When injected holes and electrons meet at the organic semiconductor including the ionic transition metal complex site they recombine to form excitons which may result in light emission. The luminescence efficiency of the organic semiconductor can be extremely high, with photoluminescence quantum yield approaching 100 %, as emission from this organic semiconductor arises almost exclusively from triplet states.

According to one embodiment, the organic functional layer comprises a salt and/or an ionic liquid. The salt and/or ionic liquid can be dispersed in the organic semiconductor. The ionic liquid can be selected from a group of 1-Benzyl-3-methylimidazolium hexafluorophosphate, 1-Butyl-2,3-dimethylimidazolium hexafluorophosphate, 1-Butyl-3-methylimidazolium hexafluorophosphate, 1-Ethyl-3-methylimidazolium hexafluorophosphate, 1-Hexyl-3-methylimidazolium hexafluorophosphate, 1-Butyl-1-(3,3,4,4,5,5,6,6,7,7,8,8,8-tridecafluorooctyl)imidazolium hexafluorophosphate, 1-Methyl-3-(3,3,4,4,5,5,6,6,7,7,8,8,8-tridecafluorooctyl)imidazolium hexafluorophosphate, 1-Methyl-3-octylimidazolium hexafluorophosphate, 1-Butyl-2,3-dimethylimidazolium tetrafluoroborate, 1-Butyl-3-methylimidazolium tetrafluoroborate, 1-Ethyl-3-methylimidazolium tetrafluoroborate, 1-Hexyl-3-methylimidazolium tetrafluoroborate, 1-Methyl-3-octylimidazolium tetrafluoroborate, 1-Butyl-3-methylimidazolium trifluoromethanesulfonate, 1-Ethyl-3-methylimidazolium trifluoromethanesulfonate, 1,2,3-Trimethylimidazolium trifluoromethanesulfonate, 1-Ethyl-3-methyl-imidazolium bis(pentafluoroethylsulfonyl)imide, 1-Butyl-3-methylimidazolium bis(trifluoromethylsulfonyl)imide, 1-Butyl-3-methylimidazolium methanesulfonate, Tetrabutylammonium bis-trifluoromethanesulfonimidate, Tetrabutylammonium methanesulfonate, Tetrabutylammonium nonafluorobutanesulfonate, Tetrabutylammonium heptadecafluorooctanesulfonate, Tetrahexylammonium tetrafluoroborate, Tetrabutylammonium trifluoromethanesulfonate, Tetrabutylammonium benzoate, Tetrabutylammonium chloride, Tetrabutylammonium bromide, 1-Benzyl-3-methylimidazolium tetrafluoroborate, Trihexyltetradecylphosphonium hexafluorophosphate, Tetrabutylphosphonium methanesulfonate, Tetrabutylphosphonium tetrafluoroborate, Tetrabutylphosphonium bromide, 1-Butyl-3-methylpyridinium bis(trifluormethylsulfonyl)imide, 1-Butyl-4-methylpyridinium hexafluorophosphate, 1-Butyl-4-methylpyridinium tetrafluoroborate, Sodium tetraphenylborate, Tetrabutylammonium tetraphenylborate, Sodium tetrakis(1-imidazolyl)borate and Cesium tetraphenylborate, and combinations thereof. In particular, the ionic liquid is 1-butyl-3-methylimidazolium hexafluorophosphate.

According to one embodiment, the organic functional layer including the ionic transition metal complex can be

applied by wet-chemical deposition techniques like coating (e.g. spin-coating, doctor balding, slot die coating) or printing (e.g. screen-printing, flexography printing, gravure printing, inkjet printing).

According to one embodiment, the organic functional layer has a layer thickness of 50 nm to 1000 nm, preferably 50 nm to 500 nm, particularly 50 nm to 150 nm, for example 100 nm.

According to one embodiment, the functional organic layer emits electromagnetic radiation in the operation mode and does not emit electromagnetic radiation in the pre-biasing mode.

According to one embodiment, the first voltage has a value between 1 to 2.49 V (borders are included).

If the first voltage is close to the band gap (-2.5 V) then for the pre-biasing and operation mode - from a physically point of view - the same voltage could be applied. In this case thermal excitation of charge carriers will trigger the light emission.

The first voltage can be a constant or pulsed value, wherein the value of the first voltage is less than and/or equal to the band gap to the first and the second electrode. In this context, a pulsed value means that the first voltage is produced in short pulses in the pre-biasing mode, wherein the maximum value of the first voltage is less than and/or equal to the band gap to the first and the second electrode. The lower level of the first voltage pulses can be positive, zero or negative whereas the upper level of the first voltage pulses can be of the range of bigger than 0 Volts to the band gap.

According to a further embodiment, the first voltage has a value between 1 to 2 V, preferably 1.5 to 2 V, particularly 1.7 to 2 V, for example 1.9 V.

According to one embodiment, the second voltage has a value between 2.5 to 5 V, preferably 2.5 to 4 V, particularly 2.5 to 2.8 V, for example 2.5 V.

Important for the pre-biasing mode is, that the first voltage applied is lower than the band-gap so that charge injection (= current flow) is prevented. It is only the ions that should move and orientate in the pre-biasing mode. After the ions have aligned the device is changed to the operation mode by applying voltages above the band gap so that electrical charge injection occurs.

"Voltage" is a potential difference between the two electrodes.

"First voltage" is a potential difference between the two electrodes in the pre-biasing mode.

"Second voltage" is a potential difference between the two electrodes in the operation mode.

The voltage, for example the first or second voltage, is needed to orientate and distribute the ions, for example the ionic transition metal complex and/or the counter-ion, inside the functional organic layer such that the anions (counter-ion) move to the anode and the cations (ionic transition metal complex) to the cathode, respectively.

In this invention the inventor proposes a pre-biasing mode that results in instant light emission of the organic electroluminescent device when the organic electroluminescent device is switched-on without sacrificing the stability.

The pre-conditioning of the organic electroluminescent device is carried out by applying the first voltage that is lower than the band-gap of the organic semiconductor or the ionic transition metal complex. Under described conditions the ions inside the functional organic layer can redistribute to form electric double layers near the electrode interfaces that as a result assist the injection of charge carriers into the functional organic layer, which emits electromagnetic radiation. As long as the first voltage applied is lower the band-gap of the organic semiconductor or the ionic transition metal complex no electromagnetic radiation is emitted as no charge injection occurs.

According to one embodiment, the pre-biasing mode includes a first current, wherein the first current is close to zero.

This results that less power is consumed. To switch-on the organic electroluminescent device in the operation mode, the organic electroluminescent device is changed to the higher second voltage greater than the band-gap, preferably to 2.5 - 5 V, to inject electrons and holes from the electrode interfaces into the functional organic layer. Light emission occurs when injected electrons and holes recombine to form excitons that luminously decay.

In a preferred embodiment, the first current is zero.

According to one embodiment, the operation mode comprises a measure selected from a group including applying a constant second voltage, inducing a constant second current, applying an alternating second voltage, inducing an alternating second current and a combination thereof.

In a preferred embodiment the second voltage is constant in the operation mode.

The operation mode comprises applying the constant second voltage. The two modes of the organic electroluminescent device could be easily realized by standard electrical circuits. Therefore no additional equipment is necessary to reduce the turn-on time without sacrificing the stability of organic electroluminescent device and/or vice versa. This offers a low cost solution for application of the organic electroluminescent device according to the present invention.

To stop the light emission by switching-off the organic electroluminescent device and switching from the operation mode into the pre-biasing mode, the voltage applied to the organic electroluminescent device is again changed to the first voltage smaller than the band gap, for example below the band gap of 1 to 2 V. Whenever the organic electroluminescent device is switched-on light is immediately emitted again.

According to one embodiment, the pre-biasing mode comprises a time period of 1 to 50 hours or less, preferably

1 to 24 hours, particularly 10 hours. The time period of the pre-biasing mode is dependent on the ionic mobility, the voltage applied and the temperature.

The "time period" means a space of time with an established starting time and endpoint of the pre-biasing mode. "time period" is also called pre-biasing time according to this invention.

According to one embodiment, the operation mode comprises a turn-on time, wherein the turn-on time is less than and/or equal to 1 minute.

In a preferred embodiment, the turn-on time is a few seconds, for example less than 30 seconds, preferably less than 1 seconds, for example 0.5 milliseconds. This results in an instant light emission of the organic electroluminescent device.

In this context, "turn-on time" is defined as the time, which is required to reach a certain luminance, e.g. 200 $cd/m^2$

According to one embodiment, the pre-biasing mode and the operation mode alternate each other.

In a preferred embodiment, the alternation of the pre-biasing mode and the operation mode is induced by a switch and/or controlled automatically.

According to one embodiment, the organic electroluminescent device is an organic light emitting electrochemical cell.

In contrast to OLEDs the structure of the organic light emitting electrochemical cell (OLEEC) is simpler as only one functional organic layer is needed. This functional organic layer can be easily applied by wet-chemical deposition technique. In contrast to organic light emitting diodes (OLEDs), the OLEEC does not need reactive electrodes (e.g. Ba, Ca, LiF, CsF, Mg), for example as low work function cathodes for the electron injection. This means that air-stable metals like Au, Al and Ag can be used in OLEECs. Therefore the requirements in terms of encapsulation are less demanding compared to typical OLED devices. In combination with the simple device structure and solution processability, OLEECs are low-cost organic electroluminescent devices.

In an embodiment, the organic electroluminescent device according to the present disclosure can be operated by the following method:

A) Provision of a substrate,

B) Provision of a first electrode and a second electrode,

C) Provision of a functional organic layer including at least one ionic component and one emitter material having a band gap between the first and the second electrode, wherein the emitter material is selected from the group of ionic transition metal complex, neutral transition metal complex, polymer emitter and combinations thereof having a band gap between the first and the second electrode (2, 4), and

D) Operating the device in a pre-biasing mode comprising applying a first voltage being a constant or pulsed value less than or equal to the band gap to the first and the second electrode.

The embodiments and definitions, which are described in the description of the organic electroluminescent device, are also valid for the method of operating an organic electroluminescent device and/or vice versa.

In principle, the method of operating can be applied for organic light emitting electrochemical cells, organic light emitting diodes (OLEDs), photovoltaic cells or transistors as organic electroluminescent device. Preferably the method of operating can be applied for organic light emitting electrochemical cells.

In a further embodiment, the method of operating an organic electroluminescent device comprising the additional process step:

E) Switching from the pre-biasing mode into an operation mode and/or vice versa, wherein a second voltage is applied to the electrodes that is higher than the band gap of the at least one ionic transition metal complex.

In a further embodiment, the functional organic layer emits immediately electromagnetic radiation when switching from the pre-biasing mode into the operation mode and/or stops immediately the emission of the electromagnetic radiation when switching from the operation mode into the pre-biasing mode.

In a further embodiment, first and second voltages are delivered by separate voltage sources.

The pre-biasing mode with a constant first voltage results in the instant emission of the electromagnetic radiation after switching on the operation mode without sacrificing the organic electroluminescent device stability and/or leading to any significant additional power consumption. That is in clear contrast to prior art, which use short pulses of high voltage (5 to 15 V) in the pre-biasing mode. This known method results in a low turn-on time but bears the risk to lead to uncontrolled degradation of the functional organic layer due to increased chemical redox-reactions of the molecules. In addition, for pre-biasing modes at high voltages or short pulses of high voltages the driving technology is much more complex and also the power consumption will be significantly higher for this known method because of the electrical current flow at higher voltages.

Further advantages and advantageous embodiments and developments of the invention will become apparent

from the embodiments described below in conjunction with figures 1 to 11.

In the exemplary embodiments and figures, identical or identically acting constituent parts may be provided in each case with the same reference symbols. The elements illustrated and their size relationships among one another should not in principle be regarded as true to scale; rather, individual elements, such as, for example, layers, structural parts, components and regions, may be illustrated with exaggerated thickness or size dimensions for the sake of better presentation and/or for the sake of better understanding.

In the figures:

| | |
|---|---|
| Figure 1 | shows a schematic illustration of an organic electroluminescent device according to one embodiment of the invention, |
| Figure 2 | shows an initial luminance $L_I$ and turn-on time $T_{200}$ of an organic electroluminescent device according to one embodiment of the invention, |
| Figure 3 | shows a luminance L of an organic electroluminescent device according to one embodiment of the invention, |
| Figure 4 | shows an initial luminance $L_I$ and turn-on time $T_{200}$ of an organic electroluminescent device according to one embodiment of the invention, |
| Figure 5 | shows a luminance L of an organic electroluminescent device according to one embodiment of the invention, |
| Figure 6 | shows a luminance L of an organic electroluminescent device according to one embodiment of the invention, |
| Figure 7 | shows a current density d of an organic electroluminescent device according to one embodiment of the invention, |
| Figure 8 | shows a power consumption P of an organic electroluminescent device according to one embodiment of the invention, |
| Figure 9 | shows a schematic illustration of a method of operating an organic electroluminescent device according to one embodiment of the invention, |
| Figure 10 | shows a schematic illustration of a method of operating an organic electroluminescent device according to one embodiment of the invention, and |
| Figure 11 | shows a schematic illustration of a method of operating an organic electroluminescent device according to one embodiment of the invention. |

Figure 1 shows a schematic illustration of an organic electroluminescent device according to one embodiment of the invention. The organic electroluminescent device is embodied as an organic light emitting electrochemical cell 100 and comprises a substrate 1, a first electrode 2 arranged on the substrate 1, a functional organic layer 3 arranged on the first electrode 2, a second electrode 4 arranged on the organic functional layer 3 and an encapsulation 5 arranged on the second electrode 4. "Arranged on" means in this case that the layers and/or elements are directly mechanically and/or electrically connected to each other. The functional organic layer 3 comprises an organic semiconductor including an ionic transition metal complex having a band gap (not shown). The organic electroluminescent device 100 works in two modes, a pre-biasing mode and operation mode, wherein a pre-biasing mode comprises applying a first voltage being a constant value less than and/or equal to the band gap to the first and the second electrode and an operation mode comprises applying a second voltage being higher than the band gap to the first and the second electrode (not shown). In the present case, by keeping the first voltage below but close to the band gap of the organic semiconductor ($\approx$ 2.5 V), the current flow through the organic electroluminescent device is comparatively small and the organic electroluminescent device and/or the organic semiconductor degradation is minimized. The electromagnetic radiation 6 can be emitted through the substrate 1 ("bottom emitter").

Organic light-emitting electrochemical cells have been prepared with the following configuration: ITO / 100nm PEDOT:PSS / 100 nm EML/ 150 nm Al, wherein ITO is indium tin oxide, PEDOT:PSS is poly(3,4-ethylenedioxythiophene) poly(styrenesulfonate). EML denotes the functional organic layer, which comprises the organic semiconductor bis-2-phenylpyridine 6-phenyl-2,2'-bipyridine iridium(III) hexafluorophosphate (OS) and the ionic liquid (IL) 1-butyl-3-methylimidazolium hexafluorophosphate in a molar ratio of OS:IL = 3:1, and Al is aluminum. The layers of PEDOT:PSS and EML have been sequentially deposited on the ITO-glass anode via spin-coating from solution, whereas the Al cathode

has been thermally evaporated.

Two different experiments have been carried out to probe the impact of the specified pre-biasing mode (Figures 2 to 3 and Figures 4 to 5).

On the one hand, in Figures 2 and 3 a fixed first voltage has been applied to the organic electroluminescent device. On the other hand, the pre-biasing time has been kept firm and the first voltage has been altered (Figures 4 and 5). For the subsequent main operation mode an AC voltage signal of OV/8V at 1 kHz, has been chosen in both cases and performance data has been recorded over time.

Figure 2 shows an initial luminance $L_I$ in cd/m$^2$ as a function of a pre-biasing-time $t_B$ in hour h and a turn-on time $T_{200}$ in min as a function of the pre-biasing-time $t_B$ in hour h at a constant first voltage of 2 V. In this context $T_{200}$ means the time to reach a luminance of 200 cd/m$^2$. It is clearly apparent, that the turn-on time $T_{200}$ can be significantly reduced by simply increasing the pre-basing time $t_B$ for a fixed first voltage (2 V), which is accompanied with a simultaneous increase in the initial luminance. After 25 h of pre-biasing, for example, after switching to the operation mode, the organic electroluminescent device shows an initial luminance of more than 200 cd/m$^2$. This is comparable to the brightness of standard television screens. Moreover, the initial luminance reaches a saturation value of 350 cd/m$^2$ by further increasing of the pre-biasing time $t_B$. This value is comparable to the backlight illumination in LCD displays. Pre-biasing-time $t_B$ means here and in the following the time period of the pre-biasing mode.

Figure 3 shows a luminance L in cd/m$^2$ as a function of time t in hour h at a constant first voltage of 2 V. V1 is a comparative embodiment comprising no pre-biasing mode ($t_B$ = 0). The exemplary embodiments of this invention show the luminance L by a different pre-biasing time $t_B$ in h and a constant first voltage of 2 V. It seems that the stability of the organic electroluminescent device is unaffected from the pre-biasing mode and pre-biasing time $t_B$. The decline of luminance is nearly the same for all organic electroluminescent devices, independent if they have been pre-biased or not as well as independent of the pie-biasing time.

The experiments clearly illustrate that target values for the brightness as it is required in electronic consumer products can be achieved with light-emitting electrochemical cells without a loss in organic electroluminescent device stability by the application of an adequate pre-biasing mode.

Figure 4 shows an initial luminance $L_I$ in cd/m$^2$ as a function of a first voltage $U_B$ in V and a turn-on time $T_{200}$ in min as a function of the first voltage $U_B$ in V at a constant pre-biasing time $t_B$ of 50 h.

To achieve a low turn-on time with desired high brightness, it is beneficial to pre-bias the organic electroluminescent device with a first voltage close to the band gap of the organic semiconductor or ionic transition metal complex, which is located around 2.5 V. It can be gathered from Fig. 4 that increasing the first voltage and therefore approaching the value of the band gap results in a decline of the turn-on time $T_{200}$ and also in a rise of the initial luminance $L_I$ when switching to the operation mode. As already shown in the case of Figure 3, the stability of the organic electroluminescent device is unaffected (Figure 5).

Figure 6 shows a luminance L in cd/m$^2$ as a function of time t in hour h of an exemplary embodiment E1 and a comparative embodiment V3.

A potential application of the method of operating an organic electroluminescent device according to the invention is to stabilize or even maintain the initial organic electroluminescent device condition in the "off-state" or pre-biasing mode. Usually, when switching off an organic electroluminescent device, i.e. no potential is applied between the electrode contacts, and turn it on again after a while, the organic electroluminescent device relaxes during the off-period and approaches its pristine condition. This behavior of the comparative embodiment V3 is exemplarily depicted in Fig. 6. After a pre-biasing mode of applying a first voltage of 2V for 25h, the organic electroluminescent device has been operated with an AC voltage signal of 2V/8V at 1 kHz for 2h and thereafter the operation mode has been paused for 5h. The last two cycles have been repeated several times.

During the "off-state" or pre-biasing mode a large drop in luminance can be observed, followed by a gradually increase again when switching on the organic electroluminescent device after the break. However, if the organic electroluminescent device is kept at a constant first voltage below the band gap during the "off-state", here 2V, only a minor drop in luminance occurs and the time to reach its maximum again is significantly decreased. By enhancing the "off-state" potential to a value corresponding exactly to the band gap of the organic semiconductor or ionic transition metal complex, the current condition of the organic electroluminescent device is assumed to be sustained during the "off-state" period or pre-biasing mode.

Figure 7 shows a current density d in mA/cm$^2$ as a function of time t in hour h.

Figure 8 shows the power consumption P in W as a function of time t in hour h.

The first voltage is 2 V for an OLEEC with an active area of 4 mm$^2$. The maximum value of d at a constant first voltage is around 0.042 mA/cm$^2$ (figure 7). This corresponds to a power consumption P of around 3.36 $\mu$W for an OLEEC with an active area of 4 mm$^2$ and to P = 1.26 mW for an OLEEC with an active area of 15 mm$^2$ (figure 8).

The ease of manufacture of OLEECs in high quality thin films in combination with the above demonstrated pre-biasing principle enables OLEECs to be introduced as possible sources for flat and large-area lighting applications, with immediate turn-on and fast switching between the on- and off-state.

Figures 9 to 11 show schematic illustrations of a method of operating an organic electroluminescent device according to one embodiment of the invention. Figure 9 shows a simple schematic illustration. Figure 10 shows a detailed schematic illustration of Figure 9. Figure 11 shows an electrical circuit for the detailed schematic illustration of Figure 10.

Figures 9 and/or 10 show a power supply A, which can be a device that supplies electric power to one or more electric loads. The power supply A can be a battery, DC power supply, AC power supply, linear regulated power supply, AC/DC supply, switched-mode power supply, programmable power supply, uninterruptible power supply or voltage multipliers.

B denotes in figure 9, 10 and/or 11 an on/off switch. The simplest on/off switch has one set of contacts (single pole) and one switching position which conducts (single throw). The switch mechanism has two positions: open (off) and closed (on). This simple on/off switch can be used to switch the power supply A to a circuit.

A controlling unit C can electronically modify the power supply A. The controlling unit C comprises a voltage source for the first voltage E and a switch for switching between the operation mode and the pre-biasing mode F.

D denotes in figure 9, 10 and/or 11 an organic electroluminescent device according to one embodiment of the invention. Preferably, the organic electroluminescent device is an organic light emitting electrochemical cell (OLEEC).

In the following, Figures 9 and 10 are simply described. The power supply A (e.g. the common line voltage) is needed, which supplies the organic electroluminescent device with a sufficient input signal. The transfer of the input signal from the power supply A to the organic electroluminescent device is controlled by an on/off switch B, whereas a controlling circuit C, which in principle also acts as a switch, differentiates between the operation mode and the pre-biasing mode.

A proper electrical controlling unit C has to be designed, which satisfies two essential requirements: On the one hand the controlling unit C has to pre-bias the organic electroluminescent device and keep it at the desired constant potential in the "off-state" or pre-biasing mode and on the other hand it has to drive the organic electroluminescent device when switching to the "on-state" or operation mode.

$V_L$ means in figure 11 a line voltage, which is the potential difference between two lines of different phases. This means there can be actually 3 line voltages on a three-phase system; A-B, A-C, and B-C. For a balanced system, the three must be equal.

A transformer T is shown in figure 11, which is a device that transfers electrical energy or power from one circuit to another through inductively coupled conductors.

D1 denotes in figure 11 a rectifier, which is an electrical device that converts alternating current (AC), which periodically reverses direction, to direct current (DC), which flows in only one direction.

R denotes in figure 11 a very low dropout voltage linear regulator, which can operate with a very small input-output differential voltage. For example, the regulator LT 3021 of Linear Technology can be used. The regulator R can operate from input supplies down to 0.9 V. This device can supply 500 mA of output current with a typical dropout voltage of 160 mV. The advantages of a low dropout voltage linear regulator include a lower minimum operating voltage, higher efficiency operation and lower heat dissipation.

R1 and/or R2 denotes in figure 11 an ohmic resistor. The resistor R1 and/or R2 obeys Ohm’s law.

$C_{EDLC}$ denotes in figure 11 a charged capacitor or an electrolytic double-layer capacitor. The charged capacitor or electrolytic double-layer capacitor comprises dielectric materials, solid conductive polymers and/or polymerized organic semiconductors.

$U_O$ denotes in figure 11 the second voltage.

$U_B$ denotes in figure 11 the first voltage.

Figure 11 shows an electrical circuit for the schematic illustration of figure 10. The transformer T and rectifier D1 can be used as a power supply A, which supplies the organic electroluminescent device with a sufficient input signal. The organic electroluminescent device works in two modes, which can be controlled by an on/off switcher B. In the case of the pre-biasing mode, the switch B is in the "off-state" and the first voltage $U_B$ is applied to the organic electroluminescent device. The low dropout voltage linear regulator R, ohmic resistors R1 and R2 and the charged capacitor $C_{EDLC}$ can generate and/or store the first voltage $U_B$. In the case of the operation mode, the switch B is in the "on-state" and the second voltage $U_O$ is applied to the organic electroluminescent device.

The time $T_C$, which defines the feed time the charged capacitor $C_{EDLC}$ is able to maintain the first voltage at the organic electroluminescent device at a constant first current drain can be calculated by the following formula.

$$T_C = \frac{C_{EDLC}(U_B - U_{\min})}{I_{OLEEC}}$$

Here $I_{OLEEC}$ is the first current through the organic electroluminescent device, $U_B$ is the first voltage (e.g. 2V),

and $U_{min}$ is a defined lower voltage limit for the first voltage.

Assuming typical values of $C_{EDLC}$ of 1 F and $U_B$-$U_{min}$ of 0.3 V and emanating from an overestimated constant current taken from the maximum in Fig. 7 defined to be necessary for sustaining the minimum first voltage $U_{min}$ of 2V a feed time of more than 49 hours can be achieved.

The invention is not restricted by the description on the basis of the exemplary embodiments. Rather, the invention encompasses any new feature and also any combination of features, in particular any combination of features in the patent claims, even if this feature or this combination itself is not explicitly specified in the patent claims or exemplary embodiments.

List of reference symbols

| | |
|---|---|
| 1 | substrate |
| 2 | first electrode |
| 3 | functional organic layer |
| 4 | second electrode |
| 5 | encapsulation |
| 6 | beam path of the electromagnetic radiation |
| 100 | organic light emitting electrochemical cell (OLEEC) |
| V1 | luminance L of a comparative embodiment comprising no pre-biasing mode ($t_B$ = 0) |
| 5h | luminance L of an organic electroluminescent device according to one embodiment of the invention comprising a pre-biasing mode with $t_B$ = 5h |
| 25h | luminance L of an organic electroluminescent device according to one embodiment of the invention comprising a pre-biasing mode with $t_B$ = 25h |
| 50h | luminance L of an organic electroluminescent device according to one embodiment of the invention comprising a pre-biasing mode with $t_B$ = 50h |
| 100h | luminance L of an organic electroluminescent device according to one embodiment of the invention comprising a pre-biasing mode with $t_B$ = 100h |
| 250h | luminance L of an organic electroluminescent device according to one embodiment of the invention comprising a pre-biasing mode with $t_B$ = 250h |
| V2 | luminance L of a comparative embodiment comprising no pre-biasing mode ($U_B$ = 0V) |
| 1V | luminance L of an organic electroluminescent device according to one embodiment of the invention comprising a pre-biasing mode with $U_B$ = 1V |
| 1,5V | luminance L of an organic electroluminescent device according to one embodiment of the invention comprising a pre-biasing mode with $U_B$ = 1,5V |
| 2V | luminance L of an organic electroluminescent device according to one embodiment of the invention comprising a pre-biasing mode with $U_B$ = 2V |
| V3 | luminance L of a comparative embodiment |
| E1 | luminance L of an organic electroluminescent device according to one embodiment of the invention |
| A | power supply |
| B | on/off switch |
| C | controlling unit |
| D | organic electroluminescent device |
| E | voltage source for the first voltage |
| F | switch |
| $V_L$ | line voltage |
| T | transformer |
| D1 | rectifier |
| R | low dropout voltage linear regulator |
| R1 | ohmic resistor |
| R2 | ohmic resistor |
| $C_{EDLC}$ | charged capacitor or electrolytic double-layer capacitor |
| $U_B$ | first voltage |
| $U_O$ | second voltage |

## Claims

1. **1.** An organic electroluminescent device comprising

   - a substrate (1),
   - a first electrode (2) arranged on the substrate (1),
   - a functional organic layer (3) arranged on the first electrode (2), wherein the functional organic layer (3) emits electromagnetic radiation,
   - a second electrode (4) arranged on the functional organic layer (3),
   - wherein the functional organic layer (3) comprises at least one ionic component and one emitter material having a band gap, wherein the emitter material is selected from the group of ionic transition metal complex, neutral transition metal complex, polymer emitter and combinations thereof,
   - wherein the organic electroluminescent device is adapted to work in two modes,
   - wherein a pre-biasing mode comprises applying a first voltage being a constant or pulsed value less than and/or equal to the band gap to the first and the second electrode (2, 4),
   - wherein an operation mode comprises applying a second voltage being higher than the band gap to the first and the second electrode (2, 4).

**2.** The organic electroluminescent device according to the preceding claim, wherein the functional organic layer (3) emits electromagnetic radiation in the operation mode and does not emit electromagnetic radiation in the pre-biasing mode.

**3.** The organic electroluminescent device according to the preceding claims, wherein the first voltage has a value between 1 to 2 V.

**4.** The organic electroluminescent device according to the preceding claims, wherein the second voltage has a value between 2.5 to 5 V.

**5.** The organic electroluminescent device according to the preceding claims, wherein the operation mode comprises a measure selected from a group including applying a constant second voltage, inducing a constant second current, applying an alternating second voltage, inducing an alternating second current and a combination thereof.

**6.** The organic electroluminescent device according to the preceding claims, wherein the pre-biasing mode includes a first current, wherein the first current is close to zero.

**7.** The organic electroluminescent device according to the preceding claims, wherein the pre-biasing mode comprises a time period of 1 to 50 hours or less.

**8.** The organic electroluminescent device according to the preceding claims, wherein the operation mode comprises a turn-on time, wherein the turn-on time is less than and/or equal to 1 minute.

**9.** The organic electroluminescent device according to the preceding claims, wherein the pre-biasing mode and the operation mode alternate each other.

**10.** The organic electroluminescent device according to the preceding claims, wherein a transition metal of the ionic transition metal complex is selected from the group including a transition metal of the platinum group of the periodic table and a transition metal of the copper group of the periodic table.

**11.** The organic electroluminescent device according to the preceding claims, which is an organic light emitting electrochemical cell (100).

**12.** A method of operating an organic electroluminescent device according to one of claims 1 to 11 with the following process steps:

A) Provision of a substrate (1),
B) Provision of a first electrode (2) and a second electrode (4),
C) Provision of a functional organic layer (3) including at least one ionic component and one emitter material, wherein the emitter material is selected from the group of ionic transition metal complex, neutral transition metal

complex, polymer emitter and combinations thereof having a band gap between the first and the second electrode (2, 4), and
D) Operating the device in a pre-biasing mode comprising applying a first voltage being a constant or pulsed value less than or equal to the band gap to the first and the second electrode (2, 4).

**13.** The method according to claim 12 comprising the additional process step:

E) Switching from the pre-biasing mode into an operation mode and/or vice versa, wherein a second voltage is applied to the electrodes (2, 4) that is higher than the band gap of the at least one ionic transition metal complex or emitter material.

**14.** The method according to claim 13, wherein the functional organic layer (3) emits immediately electromagnetic radiation when switching from the pre-biasing mode into the operation mode and/or stops immediately the emission of the electromagnetic radiation when switching from the operation mode into the pre-biasing mode.

**15.** The method according to claim 12, wherein first and second voltages are delivered by separate voltage sources.

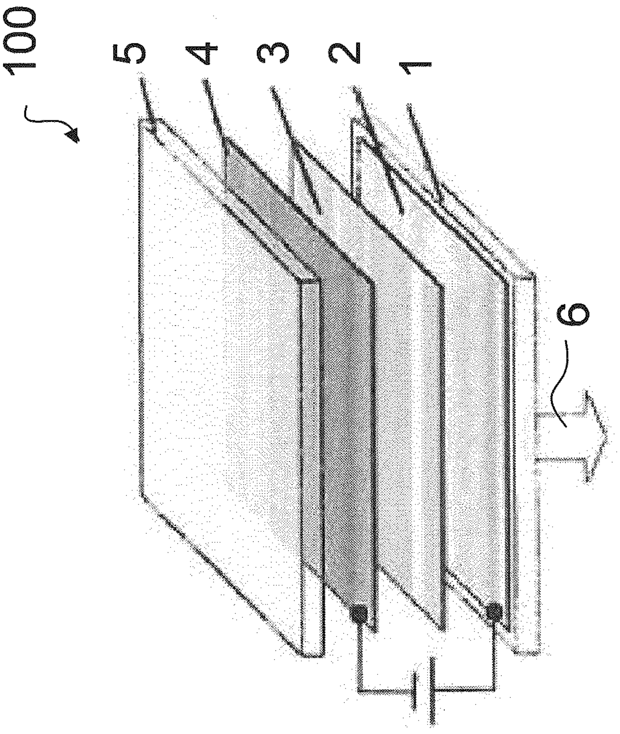


Fig. 1

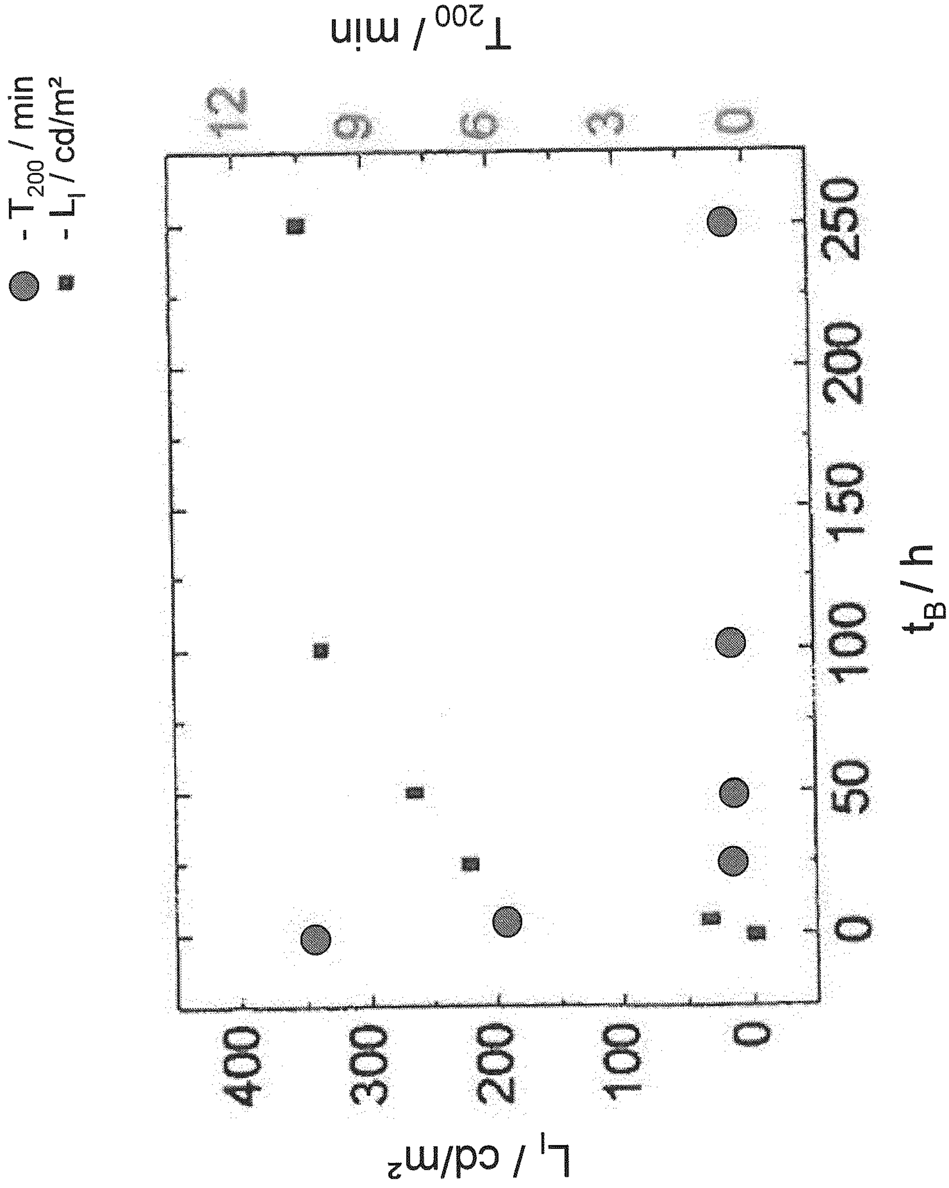

- $T_{200}$ / min
- $L_I$ / cd/m²
$t_B$ / h
$T_{200}$ / min
$L_I$ / cd/m²
0
50
100
150
200
250
0
3
6
9
12
0
100
200
300
400


Fig. 2

Fig. 3

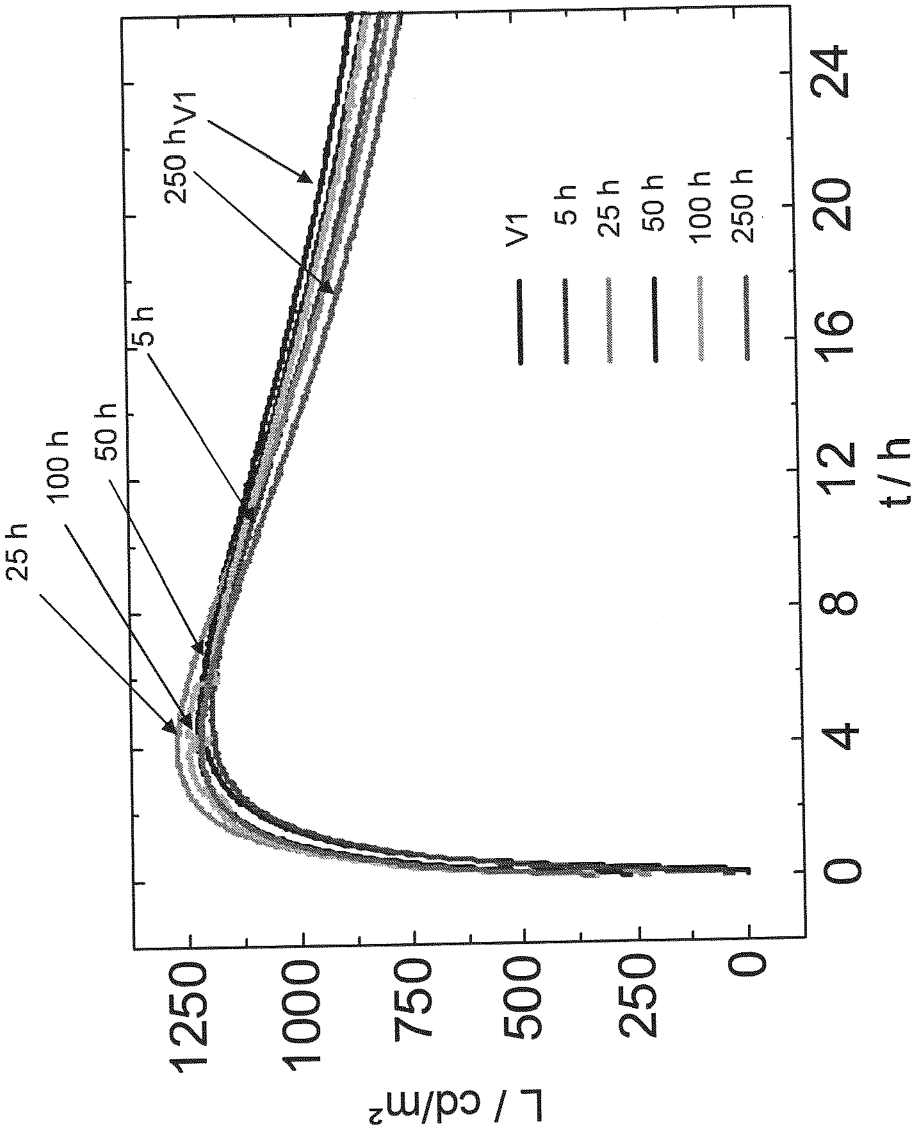

L / cd/m²
t / h
V1
5 h
25 h
50 h
100 h
250 h
0
250
500
750
1000
1250
0
4
8
12
16
20
24

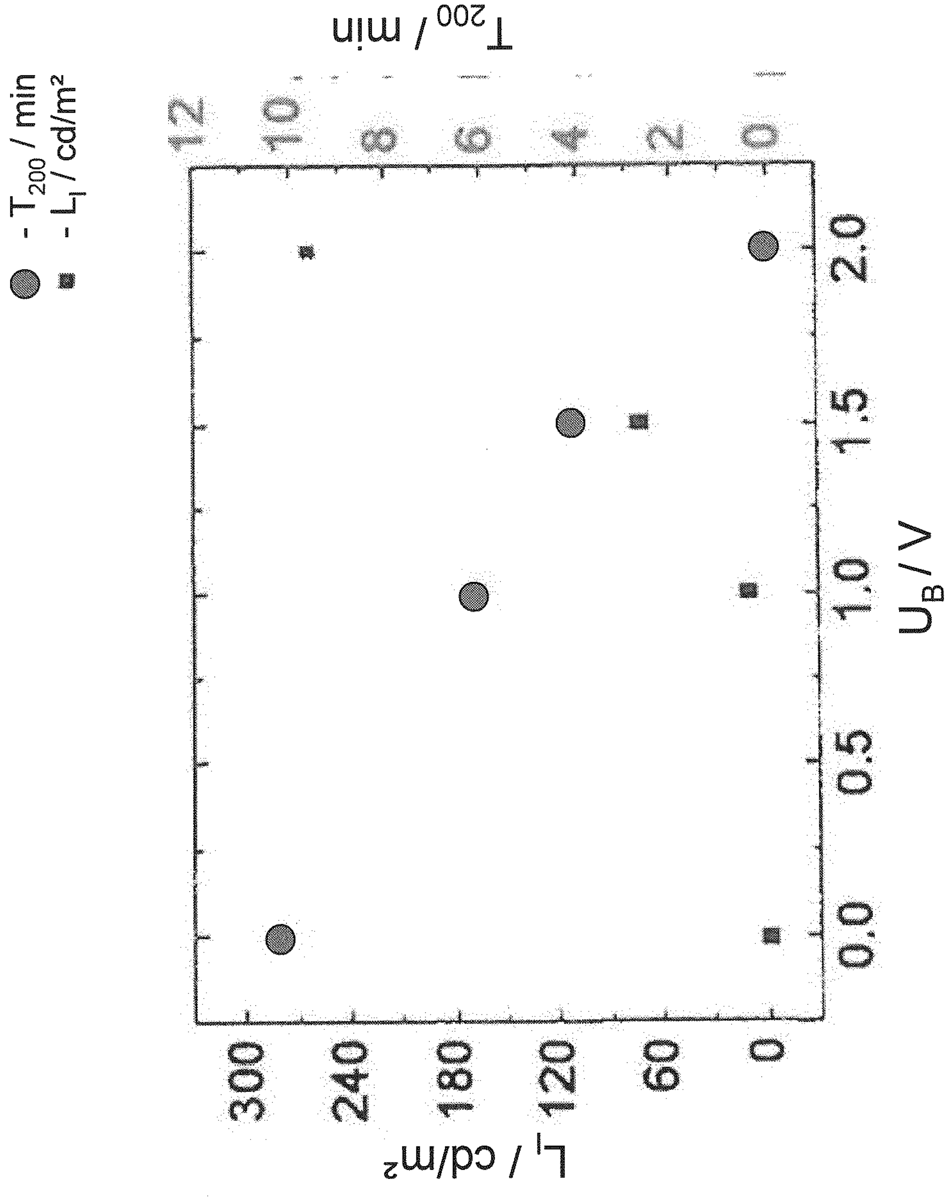

- $T_{200}$ / min
- $L_I$ / cd/m²
$T_{200}$ / min
12
10
8
6
4
2
0
$U_B$ / V
0.0
0.5
1.0
1.5
2.0
$L_I$ / cd/m²
300
240
180
120
60
0


Fig. 4

Fig. 5

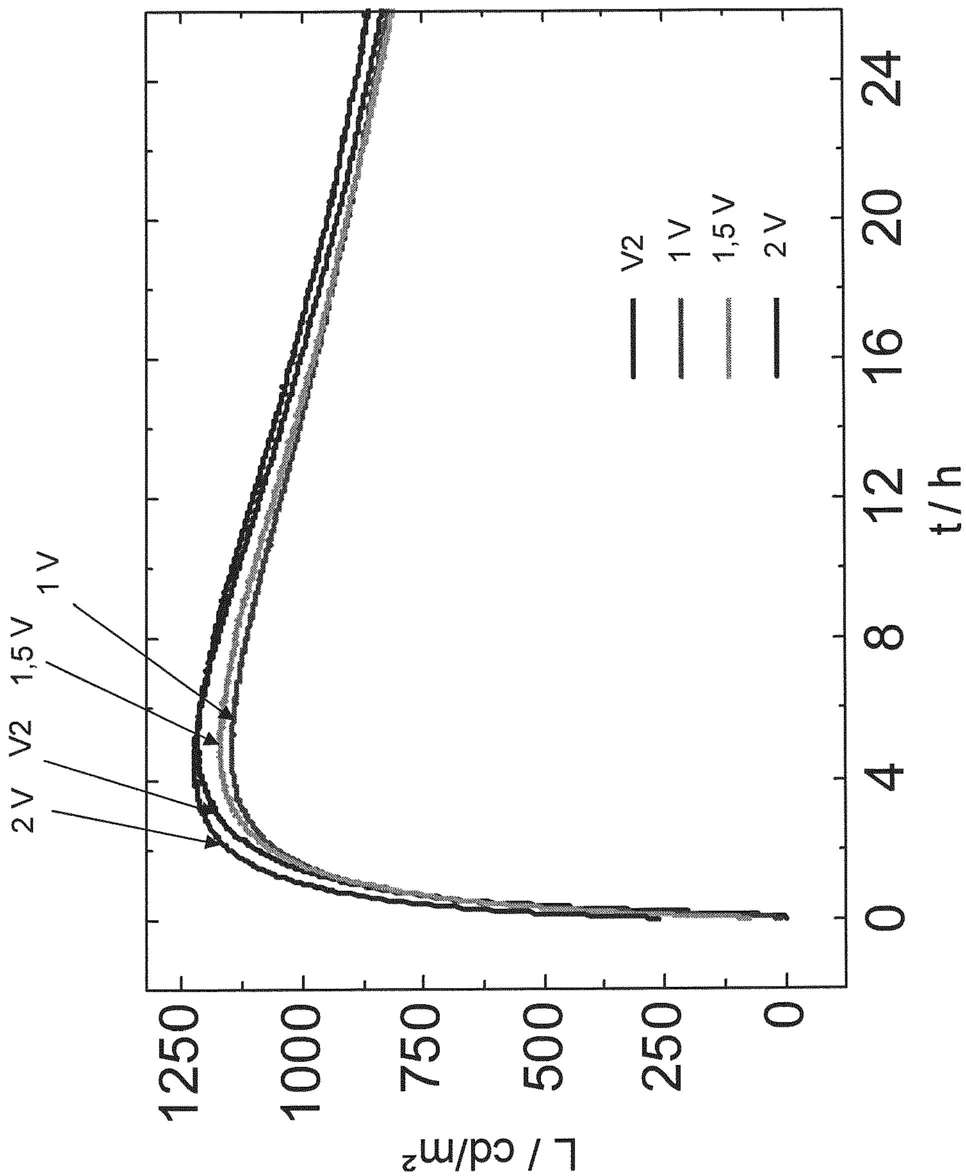
2 V
V2
1,5 V
1 V
V2
1 V
1,5 V
2 V
L / cd/m²
1250
1000
750
500
250
0
0
4
8
12
16
20
24
t / h

Fig. 6

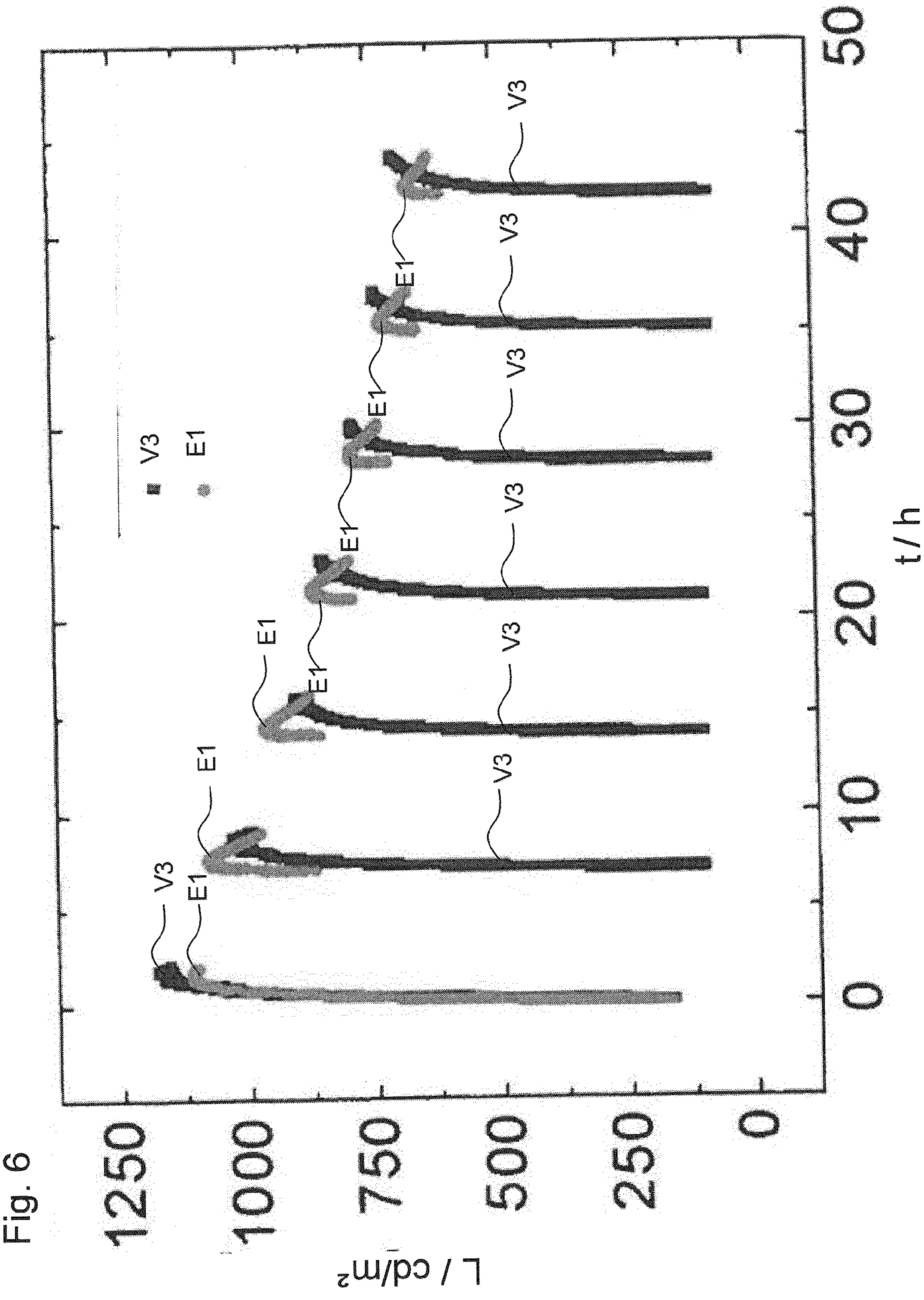

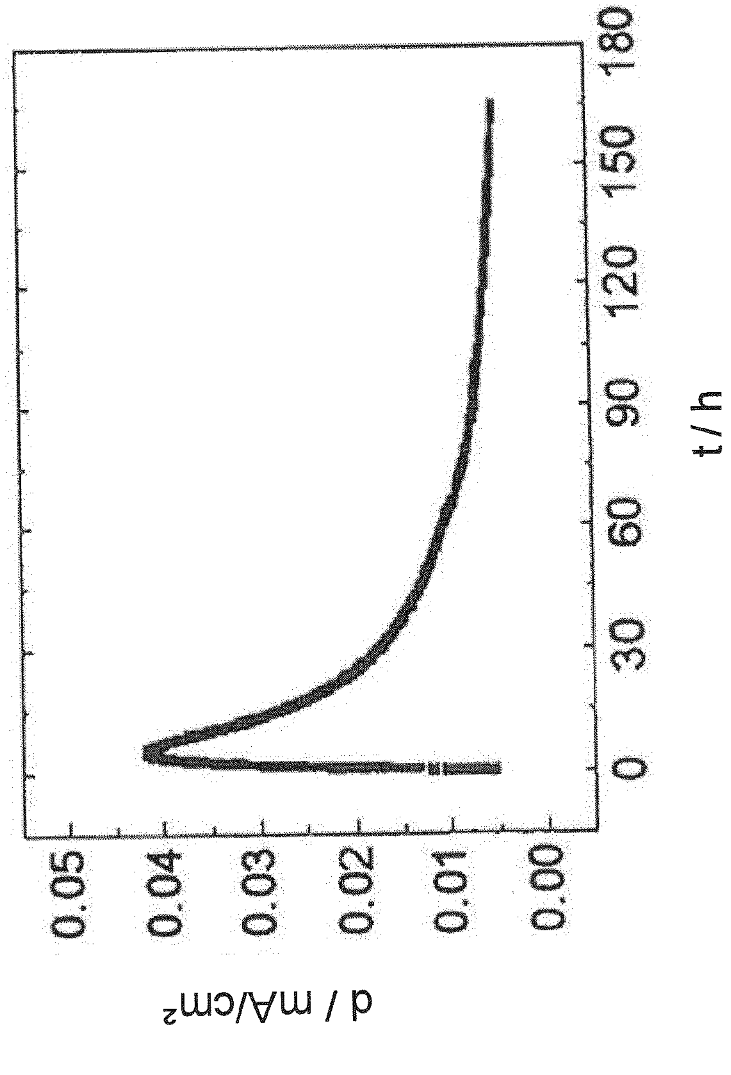


Fig. 7

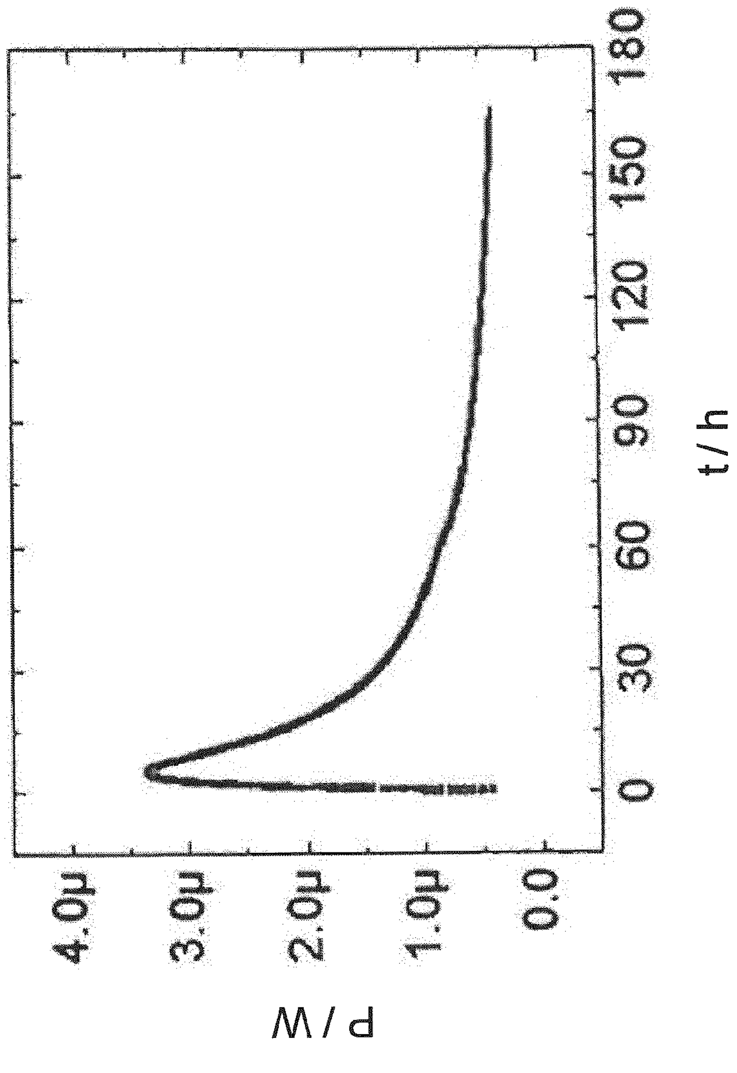


Fig. 8

Fig. 9

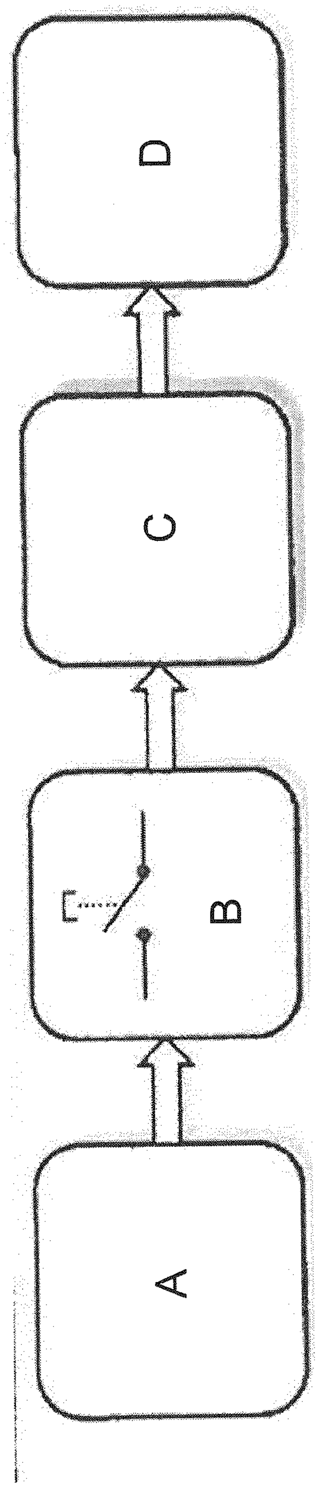

Fig. 10

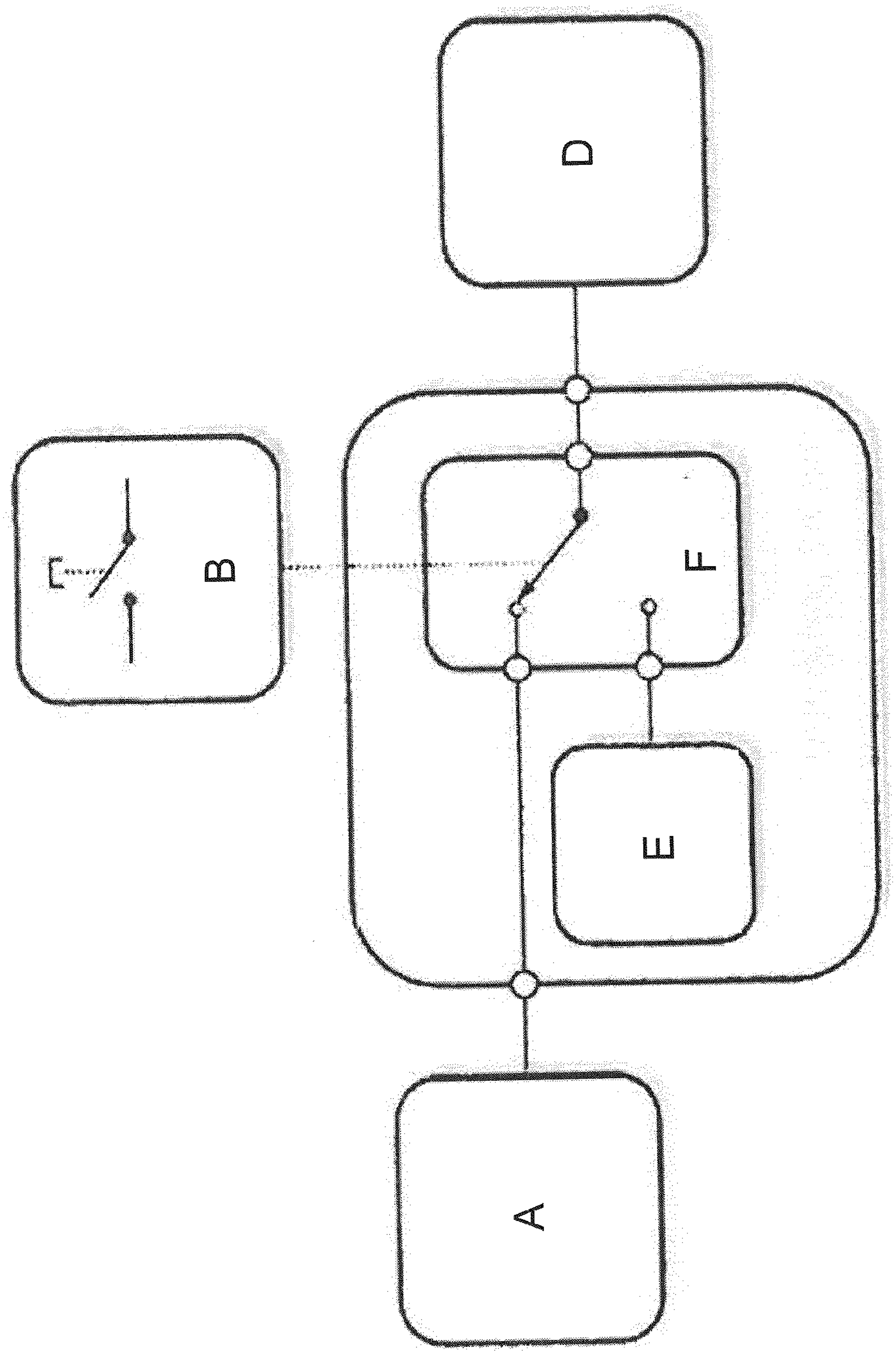

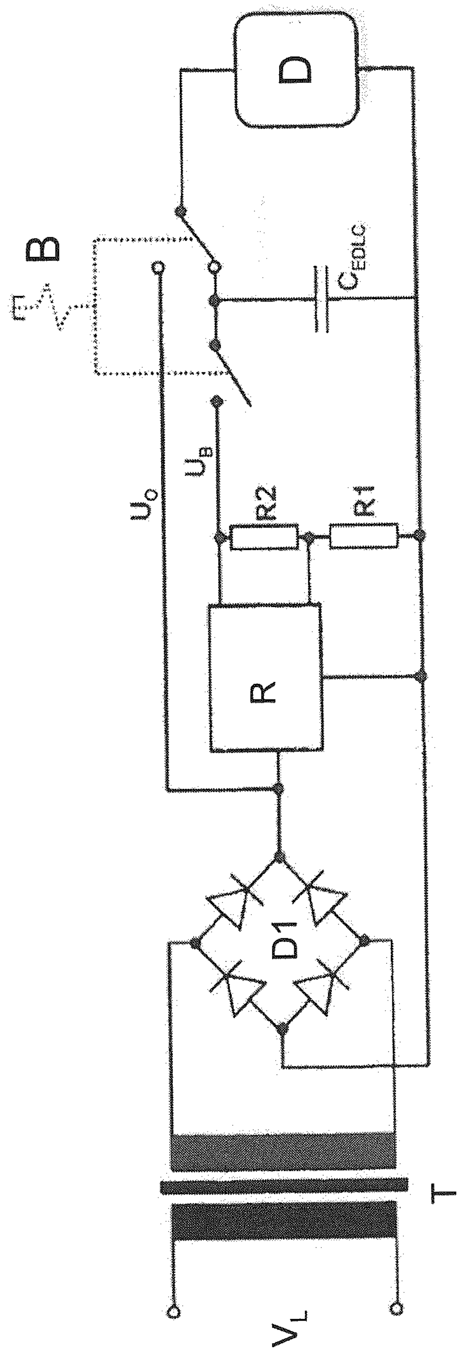


Fig. 11

Europäisches Patentamt
European Patent Office
Office européen des brevets

# EUROPEAN SEARCH REPORT

Application Number
EP 12 17 7312

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2010/085180 A1 (EDMAN LUDVIG [SE]; FANG JUNFENG [CN]; MATYBA PIOTR [SE]) 29 July 2010 (2010-07-29)<br>* page 15, line 15 - line 29; figure 3b *<br>* page 9, line 29 - page 11, line 31 *<br>----- | 1-9,11<br>10,12-15 | INV.<br>H01L51/50 |
| X | RUBÊN D. COSTA ET AL: "Improving the Turn-On Time of Light-Emitting Electrochemical Cells without Sacrificing their Stability", CHEMISTRY OF MATERIALS, vol. 22, no. 4, 23 February 2010 (2010-02-23), pages 1288-1290, XP055048982, ISSN: 0897-4756, DOI: 10.1021/cm903549u<br>* the whole document *<br>----- | 1-11 | |
| X | STEPHAN VAN REENEN ET AL: "A Unifying Model for the Operation of Light-Emitting Electrochemical Cells", JOURNAL OF THE AMERICAN CHEMICAL SOCIETY, vol. 132, no. 39, 6 October 2010 (2010-10-06), pages 13776-13781, XP055049070, ISSN: 0002-7863, DOI: 10.1021/ja1045555<br>* Experimental Section, para. 1,2 and p. 13779, col. 1, para. 2 - p. 13780, col. 1, para. 1.;<br>figures 1,4 *<br>----- | 1,11,12 | TECHNICAL FIELDS SEARCHED (IPC)<br>H01L<br>H05B |

The present search report has been drawn up for all claims

1

| Place of search | Date of completion of the search | Examiner |
|---|---|---|
| The Hague | 9 January 2013 | Bakos, Tamás |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 12 17 7312

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2013

| Patent document cited in search report | Publication date | Patent family member(s) | Publication date |
|---|---|---|---|
| WO 2010085180 A1 | 29-07-2010 | EP 2389695 A1 | 30-11-2011 |
| | | JP 2012516033 A | 12-07-2012 |
| | | US 2012019161 A1 | 26-01-2012 |
| | | WO 2010085180 A1 | 29-07-2010 |

EPO FORM P0459

For more details about this annex : see Official Journal of the European Patent Office, No. 12/82